# EUROPEAN PATENT APPLICATION

(11) **EP 2 230 762 A2**
(43) Date of publication of application: **22.09.2010**
(21) Application number: 10150258.1
(22) Date of filing: 05.12.2006
(51) Int. Cl.: H03F 3/60, H03F 3/72

(54) **Active distributed signal splitting apparatus**

(62) Divisional of application: 06838953.5
(71) Applicant: Thomson Licensing, 92130 Issy-les-Moulineaux (FR)
(72) Inventor: The designation of the inventor has not yet been filed
(74) Representative: Esselin, Sophie

(57) **Abstract**

An active distributed signal splitting apparatus (100, 200, 300) has an architecture conducive for cost-effective expandability, and provides improved features including, for example, independent frequency selection for output signals. According to an exemplary embodiment, the apparatus (100, 200, 300) includes a source of an input signal and a plurality of output points. A signal splitter including a field effect transistor (Q1) is coupled between the source of the input signal and the plurality of output points. One of the output points associated with the field effect transistor (Q1) includes a filter (10).

## Description

The present invention generally relates to signal splitting apparatuses, and more particularly, to active distributed signal splitting apparatuses having an architecture conducive for cost-effective expandability and improved features including, for example, independent frequency selection for output signals.

Signal splitting apparatuses are well-known in the art. In general, a signal splitting apparatus provides multiple output signals corresponding to a given input signal. Examples of conventional signal splitting apparatuses are shown in U.S. Patent Nos. 4,668,920 and 5,168,242. Such conventional apparatuses are deemed deficient for a variety of reasons. For example, the signal splitting apparatus disclosed in U.S. Patent No. 4,668,920 is deficient in that its architecture is not conducive for expandability. In particular, this signal splitting apparatus employs a tree-like architecture in which each new 2-way splitter section is necessarily connected to the output of the primary 2-way splitter section. This type of architecture is disadvantageous in that the overall noise figure at each output degrades substantially as the architecture is expanded. Also, this type of architecture requires additional circuits to build a signal splitting apparatus with an odd number of outputs.

Conventional signal splitting apparatuses, such as the one disclosed in U.S. Patent No. 5,168,242, are also deficient in that they fail to provide desirable features. For example, such conventional signal splitting apparatuses fail to provide independent frequency selection for output signals. As such, conventional signal splitting apparatuses provide limited functionality. Accordingly, there is a need for an improved type of signal splitting apparatus. The present invention addresses these and/or other issues.

In accordance with an aspect of the present invention, an active distributed signal splitting apparatus is disclosed. According to an exemplary embodiment, the apparatus comprises a source of an input signal and a plurality of output points. A signal splitter including a field effect transistor is coupled between the source of the input signal and the plurality of output points. One of the output points associated with the field effect transistor includes a filter.

In accordance with another aspect of the present invention, a method for processing an input signal using an active distributed signal splitting apparatus is disclosed. According to an exemplary embodiment, the method comprises steps of receiving the input signal, using a signal splitter including a field effect transistor to provide a plurality of output signals corresponding to the input signal, and filtering one of the output signals to provide a filtered output signal.

In accordance with another aspect of the present invention, another active distributed signal splitting apparatus is disclosed. According to an exemplary embodiment, the apparatus comprises means including a field effect transistor for providing a plurality of output signals from an input signal, and means for filtering one of the output signals.

The above-mentioned and other features and advantages of this invention, and the manner of attaining them, will become more apparent and the invention will be better understood by reference to the following description of embodiments of the invention taken in conjunction with the accompanying drawings, wherein:
FIG. 1 is a circuit diagram of an active distributed signal splitting apparatus according to an exemplary embodiment of the present invention;
FIG. 2 is a circuit diagram of an active distributed signal splitting apparatus according to another exemplary embodiment of the present invention; and
FIG. 3 is a circuit diagram of an active distributed signal splitting apparatus according to yet another exemplary embodiment of the present invention.

The exemplifications set out herein illustrate preferred embodiments of the invention, and such exemplifications are not to be construed as limiting the scope of the invention in any manner.

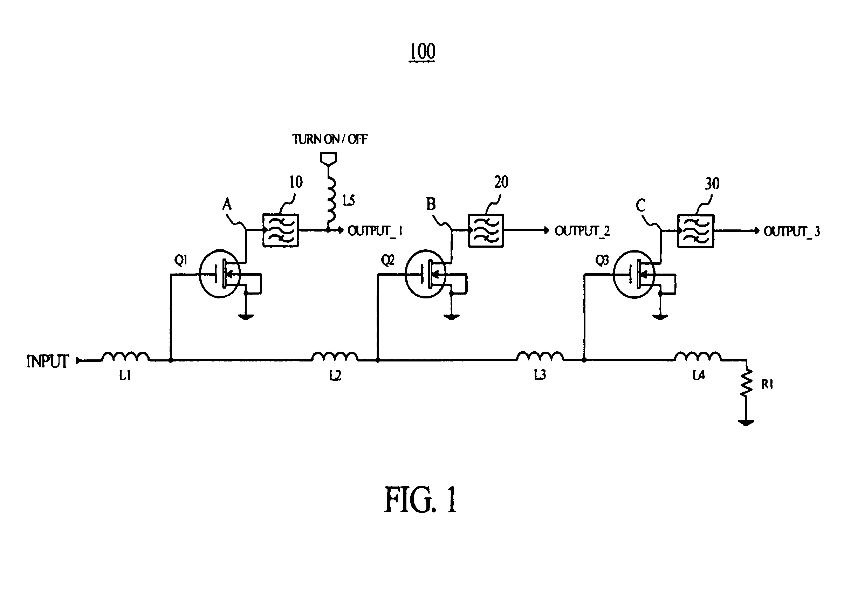

Referring now to the drawings, and more particularly to FIG. 1, a circuit diagram of an active distributed signal splitting apparatus 100 according to an exemplary embodiment of the present invention is shown. As indicated in FIG. 1, active distributed signal splitting apparatus 100 comprises an input point (INPUT), a plurality of n-channel metal oxide semiconductor field effect transistors (MOSFETs) Q1-Q3 each having an associated output point A-C, a plurality of filters 10-30, a plurality of inductors L1-L5, and a resistor R1. Active distributed signal splitting apparatus 100 employs an architecture that is conducive for cost-effective expandability without significant noise figure degradation at each output.

In general, the values of inductors L1-L5 and resistor R1 may be selected as a matter of design choice and may depend on various factors such as the nominal distributed line impedance, the desired input signal bandwidth and the distributed line capacitance which depends on the gate-source capacitance of MOSFETs Q1-Q3 plus stray capacitance. According to an exemplary embodiment, the values of inductors L1 and L4 may be one half the values of inductors L2 and L3 (i.e., inductor L1 and L4 each equaling X henries and inductors L2 and L3 each equaling X/2 henries). Resistor R1 may for example have a value of 50 or 75 ohms. Other values may also be used in accordance with design choice.

In operation, the input point (INPUT) of active distributed signal splitting apparatus 100 receives an input signal which is passed to the respective gate electrodes of MOSFETs Q1-Q3. According to an exemplary embodiment, the received input signal may be a wide band signal representing a plurality of television signals. Once the input signal is received by the respective gate electrodes of MOSFETs Q1-Q3, it is coupled and passed to the respective drain electrodes as represented as output points A-C. As shown in FIG. 1, the drain electrodes of MOSFETs Q1-Q3 are coupled to filters 10-30, respectively, and the source electrodes of MOSFETs Q1-Q3 are each coupled to ground and the body of the respective transistor.

Filters 10-30 are operative to filter the signal received via the drain electrodes of MOSFETs Q1-Q3, respectively, and thereby provide filtered output signals (OUTPUT_1-OUTPUT_3). According to an exemplary embodiment, filters 10-30 operate independently from one another and may therefore each have a different pass band. For example, if the input signal received by active distributed signal splitting apparatus 100 represents a plurality of television signals, the filtered output signals provided from filters 10-30 may each represent a different one of the television signals, or may represent different television frequency ranges, such as VHF, UHF1, UHF2, etc.

Conventional television tuners capable of receiving VHF, UHF1 and UHF2 frequency ranges are typically constructed such that each of these frequency bands is connected in parallel to a tuner input. This type of conventional design creates a challenge in order to provide a good impedance match at the tuner input (especially over a wide frequency range) because multiple frequency selective circuits are connected to the same point. In contrast, the architecture of active distributed signal splitting apparatus 100 avoids this problem and provides a simplified circuit with a good input impedance match across the whole frequency range.

The pass bands of filters 10-30 may be fixed, adjusted dynamically via control signals (not shown in FIGS.), or a combination of the two. For example, filters 10-30 may all have a fixed pass band, or may all be adjusted dynamically. As another example, filters 10 and 20 may have a fixed pass band, while filter 30 may be adjusted dynamically, or vice-versa. Any combination of fixed pass band versus adjustable pass band may be used in accordance with design choice. In this manner, filters 10-30 may independently provide filtered output signals (OUTPUT_1-OUTPUT_3) of different selected frequencies (both wide band and narrow band), which is an important advantage of the architecture of active distributed signal splitting apparatus 100.

Active distributed signal splitting apparatus 100 also includes a turn on/off feature which allows the outputs of filters 10-30 to be turned on and off independently via a control signal. This feature can be used to improve the energy efficiency of active distributed signal splitting apparatus 100. For purposes of example and explanation, signal splitting apparatus 100 is shown in FIG. 1 as having this turn on/off feature included only for the output of filter 10 (i.e., OUTPUT_1). However, the outputs of filters 20 and 30 (i.e., OUTPUT_2 and OUTPUT_3) may also include this feature. Also for purposes of example and explanation, signal splitting apparatus 100 is shown in FIG. 1 as including three (3) MOSFETS Q1-Q3 and three (3) filters 10-30. It will, however, be intuitive to those skilled in the art that a different number of such elements may also be used in accordance with design choice. In particular, active distributed signal splitting apparatus 100 can be expanded in a cost-effective manner via additional MOSFETs (and filters if desired) without significant noise figure degradation at each output.

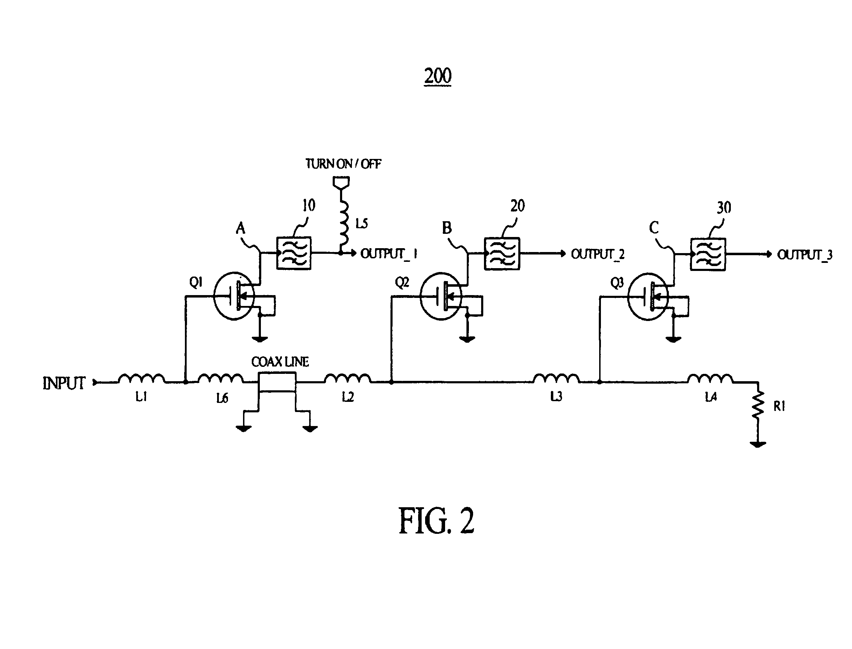

Referring to FIG. 2, a circuit diagram of an active distributed signal splitting apparatus 200 according to another exemplary embodiment of the present invention is shown. Active distributed signal splitting apparatus 200 of FIG. 2 is similar to active distributed signal splitting apparatus 100 of FIG. 1 and includes many of the same or similar elements which are identified by common reference characters. Active distributed signal splitting apparatus 200 of FIG. 2, however, shows that different stages of the circuit may physically reside at different locations and be connected via a transmission medium (e.g., coaxial cable as shown in FIG. 2) with impedance equal to the characteristic impedance of the distributed line. In FIG. 2, for example, MOSFET Q1, filter 10 and inductors L1, L5 and L6 physically reside at one location and are coupled to the remaining elements in another location via a transmission medium such as coaxial cable.

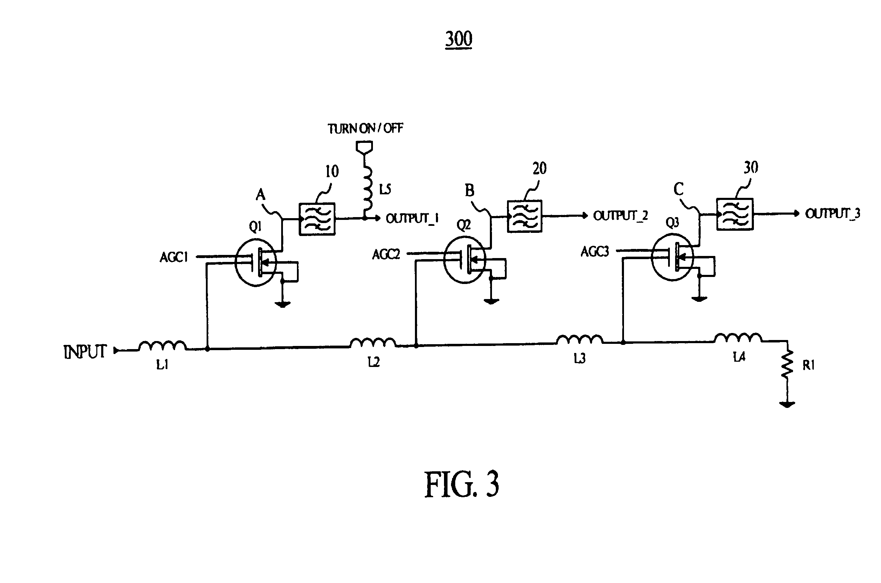

Referring to FIG. 3, a circuit diagram of an active distributed signal splitting apparatus 300 according to yet another exemplary embodiment of the present invention is shown. Active distributed signal splitting apparatus 300 of FIG. 3 is similar to active distributed signal splitting apparatuses 100 and 200 of FIGS. 1 and 2 and includes many of the same or similar elements which are identified by common reference characters. Active distributed signal splitting apparatus 300 of FIG. 3, however, shows that MOSFETs Q1-Q3 may each be equipped with dual gate electrodes in which one of the gate electrodes receives the input signal and the other gate electrode receives a gain control signal AGC1-AGC3.

According to the exemplary embodiment shown in FIG. 3, each MOSFET Q1-Q3 can be independently controlled via a separate gain control signal AGC1-AGC3 which changes the voltage applied to the applicable gate electrode. In this manner, the individual gains of the signals provided at output points A-C may be independently controlled. While FIG. 3 shows that all three MOSFETs Q1-Q3 receive a gain control signal, variations of this exemplary embodiment may include situations where at least one of the MOSFETs Q1-Q3 does not receive a gain control signal. It is also noted that aspects of the exemplary embodiments shown in FIGS. 1-3 may be combined. For example, the embodiment of FIG. 2 showing that different stages of the circuit may physically reside at different locations and be connected via a transmission medium could be combined with the embodiment of FIG. 3 in which at least one of the MOSFETs Q1-Q3 receives a gain control signal.

As described herein, the present invention provides active distributed signal splitting apparatuses having an architecture conducive for expandability, and improved features including, for example, independent frequency selection for output signals. While this invention has been described as having a preferred design, the present invention can be further modified within the spirit and scope of this disclosure. For example, although the present invention has been described herein with specific reference to MOSFETs, other types of FET technologies (e.g., CMOS, GaAs, etc.) may also be used in accordance with the principles of the present invention. Moreover, the present invention can be implemented in various ways, such as on one or more integrated circuits (ICs) or as a discrete component splitter. This application is therefore intended to cover any variations, uses, or adaptations of the invention using its general principles. Further, this application is intended to cover such departures from the present disclosure as come within known or customary practice in the art to which this invention pertains and which fall within the limits of the appended claims.

## Claims

1. An apparatus (100, 200, 300), comprising:
a source of an input signal;
a plurality of output points;
a signal splitter including a field effect transistor (Q1) coupled between said source of said input signal and said plurality of output points; and
an inductance (L1) coupled between said source of said input signal and said field effect transistor, one of said output points associated with said field effect transistor (Q1) includes a filter (10) and wherein an output of said filter (10) is turned on and off in response to a control signal.

2. The apparatus (100, 200, 300) of claim 1, wherein said field effect transistor (Q1) includes a point for receiving a gain control signal (AGC1).

3. The apparatus (100, 200, 300) of claim 1, wherein said filter (10) is coupled to a drain electrode of said field effect transistor (Q1).

4. The apparatus (100, 200, 300) of claim 1, wherein a gate electrode of said field effect transistor (Q1) is coupled to said source of said input signal.

5. The apparatus (100, 200, 300) of claim 1, wherein said signal splitter includes a plurality of field effect transistors (Q1-Q3) coupled between said source of said input signal and said plurality of output points.

6. The apparatus (100, 200, 300) of claim 5, wherein at least two of said field effect transistors (Q1-Q3) include points for receiving separate gain control signals (AGC1-AGC3).

7. The apparatus (100, 200, 300) of claim 5, wherein at least two of said output points associated with said field effect transistors (Q1-Q3) include filters (10-30).

8. A method, comprising the steps of:
receiving an input signal;
using a signal splitter including a field effect transistor (Q1) to provide a plurality of output signals corresponding to said input signal; and
filtering one of said output signals to provide a filtered output signal wherein said filtered output signal is turned on and off in response to a control signal.

9. The method of claim 8, further comprising a step of receiving a gain control signal via an electrode of said field effect transistor (Q1).

10. The method of claim 8, wherein said input signal represents a plurality of television signals and said filtering step selects a frequency corresponding to one of said television signals.

11. The method of claim 8, wherein said signal splitter includes a plurality of field effect transistors (Q1-Q3) and at least two of said field effect transistors (Q1-Q3) provide at least two different ones of said output signals.

12. The method of claim 11, wherein each of said field effect transistors (Q1-Q3) receives a separate gain control signal (AGC1-AGC3).

13. The method of claim 11, wherein each of said field effect transistors (Q1-Q3) has an associated filter (10-30) for filtering one of said output signals.
